# EUROPEAN PATENT APPLICATION

(11) **EP 4 721 924 A1**
(43) Date of publication of application: **08.04.2026**
(21) Application number: 24815614.3
(22) Date of filing: 31.05.2024
(51) Int. Cl.: B24D 11/00, B24B 37/00, B24B 57/02, B24D 3/28, H01L 21/304

(54) **POLISHING PAD AND METHOD FOR POLISHING OBJECT TO BE POLISHED**

(30) Priority: 02.06.2023 JP 2023091781
(71) Applicant: Kureha Corporation, Chuo-ku Tokyo 103-8552 (JP)
(72) Inventor: USHIRO, Kenta, Tokyo 103-8552 (JP); KUDO, Takahiro, Tokyo 103-8552 (JP); SUZUKI, Kazuyuki, Tokyo 103-8552 (JP)
(74) Representative: Hoefer & Partner Patentanwälte mbB
(86) International application number: PCT/JP2024/020042
(87) International publication number: WO 2024/248134

(57) **Abstract**

A polishing pad of the present invention includes a polishing layer. The polishing layer includes a composition containing a glycolic acid polymer and an abrasive grain.

## Description

### TECHNICAL FIELD

The present invention relates to a polishing pad and a method for polishing an object to be polished.

### BACKGROUND ART

In a processing process of a substrate to be used for a semiconductor device and the like, a cylindrical single crystal (ingot) is sliced into a disk shape to be formed into a wafer shape, and then rough polishing (lapping, primary polishing) is performed to adjust the thickness to a predetermined thickness while adjusting both surfaces of the wafer to be parallel to each other. The roughly polished wafer is further subjected to chemical etching and precision mechanical polishing (secondary polishing, mechanical polishing) for forming a mirror surface having high flatness. Finally, finish polishing (chemical mechanical polishing, CMP) in which a chemical action is also added is performed in order to obtain atomic-level planarization.

In the rough polishing processing, a polishing method using a fixed abrasive polishing pad including a polishing layer containing a binder resin and abrasive grains fixed by the binder resin is known.

As the above-described binder resin, a curable resin such as a phenol resin, an epoxy resin, or an acrylic phenol resin is usually used (see, for example, Patent Document 1).

### CITATION LIST

### PATENT DOCUMENT

Patent Document 1: JP 2018-051733 A

### SUMMARY OF INVENTION

### TECHNICAL PROBLEM

The rough polishing by the fixed abrasive polishing pad ("rough polishing" may be simply referred to as "polishing") progresses by the abrasive grains exposed on a surface of the polishing pad. At the time of polishing, the abrasive grains fall off from the polishing pad, or the abrasive grains are worn due to abrasion to cause dulling (state in which tips of the abrasive grains are abraded and flattened), and polishing performance of the polishing pad is deteriorated. Thus, it is desirable to have a structure in which the abrasive grains are fixed to the polishing pad by the binder resin, and the binder resin moderately degrades on a polishing surface of the polishing pad, so that the worn abrasive grains fall off moderately and are renewed by fresh grains, thereby maintaining continuous exposure of sharp abrasive surfaces.. However, in the polishing pad using the binder resin as described above, the binder resin is not lost except for being consumed by friction with the wafer at the time of polishing; therefore, when the polishing pad is continuously used, a proportion of the abrasive grains exposed on the polishing surface decreases, that is, renewal of the surface abrasive grains hardly occurs. Since the abrasive grains on the polishing surface are firmly fixed to the binder resin, there has been a problem that as a polishing time elapses, dulling occurs and a polishing speed decreases.

In particular, a substrate of silicon carbide (SiC), gallium nitride (GaN), or the like used for a next-generation power semiconductor device has higher hardness than a silicon (Si) substrate, and requires a long time for polishing processing. Thus, for the polishing pad, it is desired to develop a polishing pad in which a decrease in polishing speed is small even if dressing (exposing the sharp parts of new abrasive grains) is not performed in a long-time polishing treatment.

The present invention has been made in view of the above-described circumstances, and an object of the present invention is to provide a polishing pad in which a decrease in polishing speed is small even without performing dressing, and a method for polishing an object to be polished using the polishing pad.

### SOLUTION TO PROBLEM

[1] A polishing pad, including a polishing layer including a composition containing a glycolic acid polymer and an abrasive grain.
[2] The polishing pad according to [1], wherein a median diameter of the abrasive grain is 2 µm or more and 50 µm or less.
[3] The polishing pad according to [1] or [2], wherein a weight average molecular weight of the glycolic acid polymer is 70000 or more.
[4] The polishing pad according to any of [1] to [3], wherein the polishing layer further contains a hydrolysis accelerator that promotes hydrolysis of the glycolic acid polymer.
[5] The polishing pad according to any of [1] to [4], wherein the hydrolysis accelerator includes a cyclic ester.
[6] The polishing pad according to any of [1] to [5], wherein a thickness reduction rate when a molded article of the composition excluding the abrasive grains is immersed in 60°C water is 12 µm/h or more.
[7] The polishing pad according to any of [1] to [6], wherein a tensile strength of the molded article including the composition excluding the abrasive grains is 55 MPa or more.
[8] A method for polishing an object to be polished, the method including polishing the object to be polished by sliding the polishing pad and the object to be polished relative to each other while supplying, to a surface of the polishing layer of the polishing pad according to any of [1] to [7], a polishing liquid containing water.
[9] The method for polishing an object to be polished according to [8], wherein the polishing liquid is an alkaline aqueous solution.

### ADVANTAGEOUS EFFECTS OF INVENTION

According to the present invention, it is possible to provide a polishing pad in which a decrease in polishing speed is small and a method for polishing an object to be polished using the polishing pad.

### BRIEF DESCRIPTION OF THE DRAWINGS

FIG. 1A is a schematic plan view of a polishing pad according to an embodiment of the present invention, and FIG. 1B is a schematic cross-sectional view taken along line 1B-1B of the polishing pad of FIG. 1A.
FIG. 2 is a schematic cross-sectional view illustrating a method for polishing an object to be polished according to an embodiment of the present invention.
FIGS. 3A to 3C are schematic cross-sectional views illustrating a molding step in Examples.
FIGS. 4A and 4B are graphs illustrating a thickness reduction rate of compositions used in Examples and Comparative Examples.

### DESCRIPTION OF EMBODIMENTS

The present inventors have studied various binder resins for fixing abrasive grains in a polishing pad, and found that by using a hydrolyzable resin, which is moderately degraded by polishing while supplying water, as the binder resin, the abrasive grains embedded in the binder resin are easily exposed to a polishing layer surface, and a dressing effect is exhibited. Furthermore, the present inventors have found that among hydrolyzable resins, a glycolic acid polymer has higher strength and higher hydrolysis rate than other hydrolyzable resins such as polylactic acid, and thus exhibits a high polishing speed by exhibiting a high dressing effect. As a result, the present inventors have found that a decrease in polishing speed is remarkably reduced even if the dressing treatment is not performed.

That is, the polishing pad according to an embodiment of the present invention includes the polishing layer containing the glycolic acid polymer and the abrasive grains. Hereinafter, the configuration of the polishing pad will be described in detail.

### 1. Polishing pad

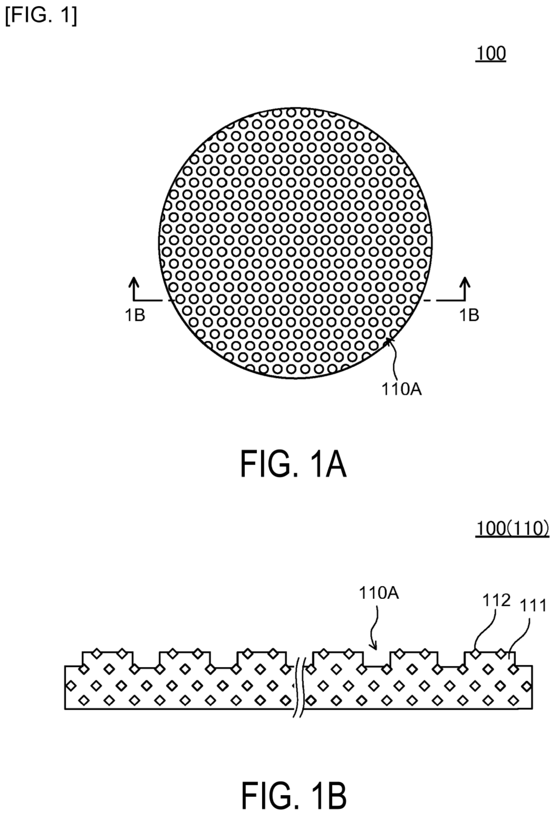

FIG. 1A is a schematic plan view of a polishing pad 100 according to an embodiment of the present invention, and FIG. 1B is a schematic cross-sectional view taken along line 1B-1B of the polishing pad 100 of FIG. 1A.

The polishing pad 100 according to the present embodiment includes a polishing layer 110 containing the glycolic acid polymer and the abrasive grains (see FIG. 1B). The polishing layer 110 includes a matrix portion 111 (matrix resin) containing a glycolic acid polymer and abrasive grains 112 fixed by the matrix portion 111. In the present embodiment, a groove 110A is disposed on a surface of the polishing layer 110, and a concave-convex pattern is applied. Although FIG. 1 illustrates an example in which the polishing pad 100 includes the polishing layer 110, the present invention is not limited thereto, and another layer may be further included.

### 1-1. Polishing layer

The polishing layer includes a composition containing the glycolic acid polymer and the abrasive grains.

### 1-1-1. Glycolic acid polymer

The glycolic acid polymer is a polymer containing a structural unit (-(-O-CH₂-CO-)-) derived from glycolic acid, and is a polymer containing the structural unit derived from glycolic acid as a main component. The glycolic acid polymer may be a homopolymer of glycolic acid or a copolymer of glycolic acid and a monomer copolymerizable therewith.

Examples of copolymerizable monomers include glycols such as ethylene glycol, propylene glycol, butanediol, heptanediol, hexanediol, octanediol, nonanediol, decanediol, 1,4-cyclohexane dimethanol, neopentyl glycol, bisphenol A, polyethylene glycol, polypropylene glycol, and polytetramethylene glycol; dicarboxylic acids such as oxalic acid, adipic acid, sebacic acid, azelaic acid, dodecanedioic acid, malonic acid, glutaric acid, cyclohexane dicarboxylic acid, terephthalic acid, isophthalic acid, phthalic acid, naphthalene dicarboxylic acid, bis(p-carboxyphenyl)methane, anthracene dicarboxylic acid, 4,4'-diphenyl ether dicarboxylic acid, 5-sodium sulfoisophthalic acid, and 5-tetrabutyl phosphonium isophthalic acid; hydroxycarboxylic acids such as lactic acid, hydroxypropionic acid, hydroxybutyric acid, hydroxyvaleric acid, hydroxycaproic acid, and hydroxybenzoic acid; lactides; lactones such as caprolactone, valerolactone, propiolactone, undecalactone, and 1,5-oxepan-2-one; and carbonates such as trimethylene carbonate.

Containing the structural unit derived from glycolic acid as a main component means that a content ratio of the structural unit derived from glycolic acid is 50 mass% or more with respect to a total amount of structural units included in the glycolic acid polymer. The content of the structural unit derived from glycolic acid is preferably 70 mass% or more, more preferably 80 mass% or more, still more preferably 90 mass% or more, and particularly preferably 95 mass% or more. When the content ratio of the structural unit included in the glycolic acid polymer is 50 mass% or more, the strength of the glycolic acid polymer can be further maintained, so that more sufficient strength can be obtained when used for a polishing pad. In addition, when the content ratio of the structural unit included in the glycolic acid polymer is 70 mass% or more, hydrolysis more easily proceeds, so that the decrease in polishing speed can be further reduced.

Among them, the glycolic acid polymer is preferably a homopolymer of glycolic acid from the viewpoint of higher strength and ease of hydrolysis.

A weight average molecular weight of the glycolic acid polymer is not particularly limited, and is preferably 70000 or more and 500000 or less. When the weight average molecular weight of the glycolic acid polymer is 70000 or more, the strength of the glycolic acid polymer can be further enhanced, and thus the retentivity and durability of the abrasive grains can be further enhanced. In addition, it is possible to obtain more sufficient strength for handling such as when removing the polishing pad from a mold at the time of molding or when attaching the polishing pad to a platen of a polishing apparatus. When the weight average molecular weight of the glycolic acid polymer is 500000 or less, not only moldability can be further maintained, but also a time until degradation by hydrolysis can be further shortened. From the same viewpoint, the weight average molecular weight of the glycolic acid polymer is more preferably 90000 or more and 400000 or less, still more preferably 100000 or more and 350000 or less, and particularly preferably 110000 or more and 300000 or less.

The weight average molecular weight of the glycolic acid polymer can be measured by gel permeation chromatography (GPC). The measurement conditions can be as follows.

### Measurement conditions

Device: "Shodex-104", available from Showa Denko K.K.
Columns: two HFIP-606M and, as a precolumn, one HFIP-G were connected in series
Column temperature: 40°C
Eluent: HFIP solution in which 5 mM sodium trifluoroacetate is dissolved
Flow rate: 0.6 mL/min
Detector: RI (differential refractive index) detector
Molecular weight calibration: five types of standard polymethylmethacrylates having different molecular weights

The content of the glycolic acid polymer is preferably 20 mass% or more and 90 mass% or less, more preferably 30 mass% or more and 80 mass% or less, still more preferably 40 mass% or more and 70 mass% or less, and particularly preferably 43 mass% or more and 52 mass% or less, with respect to the polishing layer (or the total amount of the composition). When the content of the glycolic acid polymer is 20 mass% or more, the strength of the polishing layer containing abrasive grains is further increased, which is preferable. When the content of the glycolic acid polymer is 90 mass% or less, a proportion of the abrasive grains is not too small, and thus the decrease in polishing speed can be suppressed, which is preferable. When the content of the glycolic acid polymer is as described above, it is easy to obtain a more stable polishing speed by the dressing effect while suppressing excessive degradation of the polishing layer.

### 1-1-2. Abrasive grain

The material of the abrasive grains is not particularly limited, and examples thereof include diamond, silicon carbide, boron carbide, boron nitride, silicon nitride, cerium oxide, aluminum oxide, zirconium oxide, silicon oxide, iron oxide, manganese oxide, magnesium oxide, calcium oxide, barium oxide, zinc oxide, titanium oxide, chromium oxide, barium carbonate, and calcium carbonate. Among them, diamond, boron carbide, and boron nitride are preferable from the viewpoint of further increasing the polishing speed, and diamond is more preferable from the viewpoint of facilitating processing of a substrate having high hardness such as a SiC substrate.

A median diameter of the abrasive grains depends on a required polishing degree, and is preferably, for example, 2 µm or more and 50 µm or less, more preferably 3 µm or more and 40 µm or less, still more preferably 5 µm or more and 20 µm or less, and particularly preferably 6 µm or more and 15 µm or less. When the median diameter of the abrasive grains is 2 µm or more, the polishing speed of the object to be polished can be increased, which is preferable. When the median diameter of the abrasive grains is 50 µm or less, a depth of a damaged layer of the object to be polished can be reduced, which is preferable.

The median diameter of the abrasive grains can be determined from a particle size distribution measured in accordance with a particle diameter analysis-laser diffraction/scattering method (ISO 13320:2020).
Specifically, measurement can be performed using a laser diffraction particle size analyzer (for example, Mastersizer 3000 available from Malvern Instruments) under conditions of a measurement temperature of 21°C, an ion-exchanged water as a dispersion medium, a dispersion medium refractive index of 1.330, and Mie theory as a light scattering model.

An average particle size of the abrasive grains may be, for example, 1 nm or more and 1 mm or less. The average particle size of the abrasive grains can also be measured in the same manner as described above.

The content of the abrasive grains is not particularly limited, and is preferably 10 mass% or more and 80 mass% or less with respect to the polishing layer (or the total amount of the composition). When the content of the abrasive grains is 10 mass% or more, the polishing speed can be further increased. When the content of the abrasive grains is 80 mass% or less, moldability or processability to the polishing pad can be further enhanced. From the same viewpoint, the content of the abrasive grains is more preferably 20 mass% or more and 70 mass% or less, still more preferably 30 mass% or more and 60 mass% or less, and particularly preferably 48 mass% or more and 57 mass% or less with respect to the polishing layer (or the total amount of the composition).

The content of the abrasive grains can be measured by a thermogravimetric analysis (TGA) apparatus.
Specifically, on a surface of the polishing layer of the unused polishing pad, when an arbitrary straight line passing through a center O of the polishing layer is defined as a straight line L, and a straight line passing through the center O of the polishing layer perpendicularly to the straight line L is defined as a straight line M, and when the center O of the polishing layer and a middle point between the center O of the polishing layer and an end of the polishing layer on the straight line L are defined as a1 and a2, and a middle point between the center O of the polishing layer and an end of the polishing layer on the straight line M is defined as b1 and b2, 100 mg or more of measurement samples are collected from the polishing layer from a range including measurement points of O, a1, a2, b1, and b2, and appropriately pulverized to obtain measurement samples from the respective measurement points. 20±2 mg of the measurement sample was placed in a platinum pan, and the temperature was raised from room temperature to 800°C at a rate of 10°C/min in an air atmosphere, and held at 800°C for 30 minutes, components other than the abrasive grains were burned and removed, and the remaining sample weight was divided by the mass of the measurement sample to determine the content of the abrasive grains in the polishing layer at each measurement point. In the present application, an arithmetic average value of the abrasive grain content of each of the five points was defined as a representative value of the content of the abrasive grains of the polishing layer.

### 1-1-3. Other components

The composition may further contain components other than the glycolic acid polymer and the abrasive grains. Examples of other components include resins other than the glycolic acid polymer, and hydrolysis accelerators. Among them, from the viewpoint of further increasing the polishing speed, the composition preferably further contains a hydrolysis accelerator. One type of hydrolysis accelerators may be used alone, or two or more types of hydrolysis accelerators may be used in combination.

The hydrolysis accelerator is a compound that accelerates a hydrolysis reaction of the glycolic acid polymer, and is preferably, for example, a compound that accelerates the penetration of a solution into the glycolic acid polymer by being eluted in a polishing liquid, and is more preferably a compound that generates an acid or an alkali in the presence of water. Examples of such degradation accelerators include carboxylic anhydrides, phosphorus compounds, cyclic esters, and basic metal oxides.

Examples of the carboxylic acid anhydride include hexanoic anhydride, octanoic anhydride, decanoic anhydride, lauric anhydride, myristic anhydride, palmitic anhydride, stearic anhydride, benzoic anhydride, succinic anhydride, maleic anhydride, phthalic anhydride, trimellitic acid anhydride, tetrahydrophthalic anhydride, butanetetracarboxylic dianhydride, benzophenone-3,3',4,4'-tetracarboxylic dianhydride, diphenylsulfone tetracarboxylic dianhydride, biphenyltetracarboxylic dianhydride, ethyleneglycol bisanhydrotrimellitate, and glycerin bis anhydrotrimellitate monoacetate. Among them, phthalic anhydride, trimellitic acid anhydride, benzoic anhydride, benzophenone-3,3',4,4'-tetracarboxylic dianhydride, and benzene-1,2,4,5-tetracarboxylic anhydride (pyromellitic anhydride) are preferable.

The phosphorus compound is preferably an organic phosphorus compound such as a phosphoric acid ester and a phosphite ester, and more preferably an organic phosphorus compound having at least one selected from the group consisting of a long-chain alkyl group having from 8 to 24 carbons, an aromatic ring, and a pentaerythritol skeleton.

Examples of the phosphoric acid ester having a long-chain alkyl group having from 8 to 24 carbons include mono- or di-stearyl acid phosphate or their mixture, and di-2-ethylhexyl acid phosphate.
Examples of the phosphite ester having an aromatic ring include tris(nonylphenyl) phosphite.
Examples of the phosphite ester having a pentaerythritol skeleton include cyclic neopentanetetraylbis(2,6-di-tert-butyl-4-methylphenyl)phosphite, cyclic neopentanetetraylbis(2,4-di-tert-butylphenyl)phosphite, and cyclic neopentanetetraylbis(octadecyl)phosphite.

Examples of cyclic esters include glycolide, lactide, ε-caprolactone, γ-valerolactone, δ-valerolactone, diglycolic anhydride, and glutaric anhydride.

Examples of basic metal oxides include magnesium oxide, zinc oxide, calcium oxide, sodium oxide, and copper oxide.

Among them, a cyclic ester is preferable, and glycolide is more preferable from the viewpoint of relatively stably existing at the time of molding and further promoting the hydrolysis of the glycolic acid polymer in the polishing layer in which water has permeated.

The content of the hydrolysis accelerator is preferably 0.5 mass% or more and 50 mass% or less with respect to the total amount of the glycolic acid polymer. When the content of the hydrolysis accelerator is 0.5 mass% or more, the hydrolysis of the glycolic acid polymer can be further promoted, and the decrease in the polishing speed can be further reduced. When the content of the hydrolysis accelerator is 50 mass% or less, not only bleeding out of the hydrolysis accelerator can be made more difficult to occur, but also excessive collapse due to excessive progress of hydrolysis can be further suppressed. From the same viewpoint, the content of the hydrolysis accelerator is more preferably 1 mass% or more and 30 mass% or less, and still more preferably 10 mass% or more and 25 mass% or less.

The thickness of the polishing layer is not particularly limited, and, for example, when the polishing layer is used for processing a substrate of a semiconductor device, the thickness is preferably 0.1 mm or more and 50 mm or less, more preferably 0.3 mm or more and 30 mm or less, still more preferably 0.4 mm or more and 10 mm or less, and particularly preferably 0.5 mm or more and 5 mm or less. When the thickness of the polishing layer is 0.1 mm or more, it is preferable from the viewpoint that the polishing layer can sufficiently hold the abrasive grains.

### 1-1-4. Physical properties

### Thickness reduction rate

A thickness reduction rate when a molded article of the composition (matrix resin) excluding the abrasive grains is immersed in 60°C water is preferably 12 µm/h or more. The polishing layer containing the composition having such a thickness reduction rate is easily hydrolyzed by supplying the polishing liquid, and the dressing effect is more easily obtained. The upper limit value of the thickness reduction rate is not particularly limited, and is preferably 2 mm/h or less, more preferably 1 mm/h or less, still more preferably 500 µm/h or less, and particularly preferably 100 µm/h or less from the viewpoint of extending the life of the polishing pad.

The thickness reduction rate can be measured by the following procedure.
1) The composition containing no abrasive grains is injection-molded to obtain a square column of 10 mm × 10 mm × 120 mm, and a cubic test piece (molded article) having a side of 10 mm is obtained from the square column. The molded article of the composition not containing the abrasive grains can also be obtained by heating and melting the molded article of the composition containing the abrasive grains, that is, the polishing layer. The polishing layer is heated and melted, the resulting melt is passed through a filter, and separated into a composition containing abrasive grains and a hydrolyzable resin other than the abrasive grains, that is, a composition not containing the abrasive grains, and the composition not containing the abrasive grains is molded to prepare a molded article, which can be used as a test piece.
2) Next, the test piece is placed in a 1 L autoclave, the autoclave is filled with 60°C water (deionized water), the test piece is completely immersed at ambient pressure, and the operation is repeated to prepare test pieces with different immersion times.
   Each immersion test piece is cut to expose a cross-section. After drying, a thickness of a core portion (hard portion) of the test piece is measured. A reduced thickness is measured from a difference from a thickness before immersion (10 mm).
3) The change of the reduced thickness of the test piece over time is determined based on the measured value of the reduced thickness of the test piece measured for different immersion time periods. Then, the thickness reduction rate (unit: mm/h) of the test piece having a thickness of 10 mm is calculated from the time variation for the reduced thickness of the test piece in a range where the reduced thickness of the test piece has linear variation over time.

The thickness reduction rate of the composition excluding the abrasive grains can be adjusted by, for example, the type of binder resin, and the type and content of the hydrolysis accelerator. For example, when the binder resin is a glycolic acid polymer, the thickness reduction rate tends to increase. When the content of the hydrolysis accelerator is high, the thickness reduction rate tends to increase.

### Tensile Strength

A tensile strength at 25°C of the composition excluding the abrasive grains is preferably 55 MPa or more. When the tensile strength is 55 MPa or more, a retention force of the abrasive grains can be further increased. From the same viewpoint, the tensile strength is more preferably 60 MPa or more. The tensile strength can be measured according to ISO527.

### Tensile modulus of elasticity

A tensile modulus of elasticity at 25°C of the composition excluding the abrasive grains is preferably 1 GPa or more. When the tensile modulus of elasticity is 1 GPa or more, it is possible to make it difficult for the abrasive grains protruding from the surface to be pushed back to the matrix resin when a load is applied by bringing the polishing pad into contact with the object to be polished. As a result, a decrease in the polishing speed can be further reduced. In addition, it is possible to reduce edge roll-off (a phenomenon in which an edge portion is intensively scraped and dimensional precision is lowered) of the object to be polished after polishing. From the same viewpoint, the tensile modulus of elasticity of the composition is more preferably 3 GPa or more, and still more preferably 5 GPa or more. The upper limit of the tensile modulus of elasticity is not particularly limited, and can be, for example, 50 GPa or less. The tensile modulus of elasticity can be measured according to ISO527.

The tensile strength and the tensile modulus of elasticity can be adjusted by the type and content of the hydrolyzable resin, the type and content of the hydrolysis accelerator, the weight average molecular weight, a cooling step at the time of molding, and the like. For example, when the content of the hydrolysis accelerator is low, the tensile strength tends to increase.

### 1-1-5. Shape

In the present embodiment, as described above, the groove 110A may be formed on the surface of the polishing layer 110 as necessary (see FIGS. 1A and 1B). As a result, a polishing liquid containing water can be easily spread over the entire surface of the polishing layer 110 through the groove 110A, and scraps generated by hydrolysis of the glycolic acid polymer can be easily discharged to the outside through the groove 110A.

### 1-2. Other layers

As described above, the polishing pad 100 may further include other layers as necessary. Examples of other layers include a substrate layer and an adhesive layer. The substrate layer can be, for example, a resin film. The adhesive layer can be an adhesive layer for attaching the polishing pad 100 to a polishing platen (platen 210 described later).

### 2. Method of manufacturing polishing pad

The polishing pad according to the present embodiment can be manufactured by any method. For example, a polishing pad can be manufactured through the steps of: 1) obtaining a composition containing a glycolic acid polymer and abrasive grains; and 2) molding the obtained composition.

### Step of 1)

The composition can be obtained by any method. For example, the composition can be obtained by kneading a glycolic acid polymer and abrasive grains. As a kneader, for example, a roll, a kneader, a Banbury mixer, an extruder (uniaxial or multiaxial extruder), or the like can be used.

The kneading is preferably performed under heating from the viewpoint of enhancing processability. The heating temperature can be, for example, 180°C or higher and 270°C or lower. In particular, when the composition contains a hydrolysis accelerator, the heating temperature is preferably a temperature at which the hydrolysis accelerator can be dispersed in a stable state.

The form of the composition to be obtained is not particularly limited, and may be, for example, a pellet form, a powder form, or a filament form.

### Step of 2)

Next, the obtained composition is formed into a predetermined shape. The molding method is not particularly limited, and may be, for example, any of an injection molding method, a melt extrusion molding method, a solidification- and extrusion-molding method, a vacuum molding method, a transfer molding method, and a compression molding method. Furthermore, molding by a 3D printer may be performed.

When a molded article is produced by a compression molding method, pellets of the composition are supplied into a mold. Then, the mold temperature is set to 180°C or higher and 270°C or lower, and press molding is performed to obtain a polishing pad containing a molded product.

In the present embodiment, a groove may be formed on the surface of the polishing layer obtained by forming. The method for forming a groove is not particularly limited, and the groove may be formed by cutting the surface of the molded article of the composition, or the groove may be formed by molding the composition using a mold or template in which a pattern corresponding to the groove is formed. Annealing may be performed as necessary from the viewpoint of enhancing dimensional stability of the molded product.

### 3. Method for polishing object to be polished

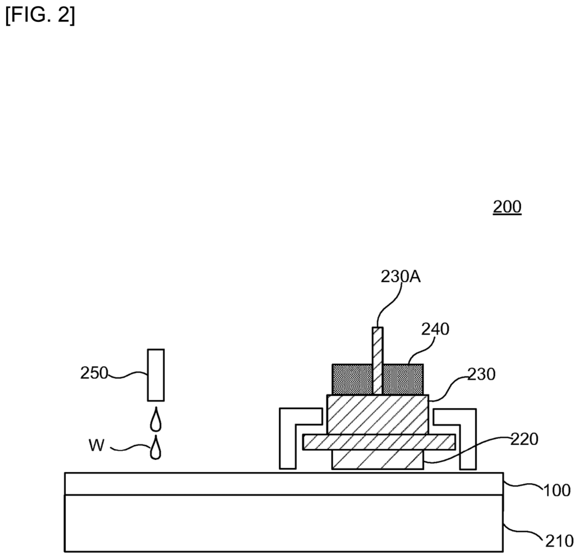

FIG. 2 is a schematic view illustrating a polishing apparatus 200 using the polishing pad 100 according to the present embodiment. In the drawing, the detailed illustration of the polishing pad 100 is omitted.

As illustrated in FIG. 2, the polishing apparatus 200 includes the polishing pad 100, the disk-shaped platen 210 that supports the polishing pad 100, a disk-shaped polishing head 230 that holds an object to be polished 220, a weight 240, and a supply nozzle 250 that supplies a polishing liquid W. The platen 210 is rotatable by a rotation shaft (not illustrated), and the polishing head 230 is rotatable by a rotation shaft 230A.

In the present embodiment, the polishing pad 100 and the object to be polished 220 are slid relative to each other while the polishing liquid W containing water is supplied to a surface of the polishing pad 100, thereby polishing the object to be polished 220.

Specifically, first, the polishing pad 100 is attached to the platen 210. Next, the object to be polished 220 held by the polishing head 230 is pressed against a polishing surface of the polishing pad 100, and the platen 210 and/or the polishing head 230 are rotated while the polishing liquid W is supplied from the supply nozzle 250. As a result, the polishing pad 100 and the object to be polished 220 are slid relative to each other to polish a processing surface (surface to be polished) of the object to be polished 220.

The type of the object to be polished 220 is not particularly limited, and examples thereof include materials for semiconductor devices, electronic components, and the like, particularly Si substrates, SiC substrates, GaAs substrates, glass, and substrates for hard disks and LCDs (liquid crystal displays). Among them, a semiconductor wafer is preferable, and a SiC substrate, a sapphire substrate, or a GaN substrate used for a power device is more preferable.

The polishing liquid W contains at least water. From the viewpoint of promoting the hydrolysis of the glycolic acid polymer contained in the polishing pad 100 and further enhancing the dressing effect, the polishing liquid W is preferably an alkaline or acidic aqueous solution, and more preferably an alkaline aqueous solution. In an alkaline aqueous solution, a carboxylic acid terminal generated by hydrolysis remains as a carboxylate ion, and an oligomer of a polymer generated by hydrolysis is easily eluted into a liquid. Thus, an alkaline aqueous solution can further promote hydrolysis as compared with an acidic aqueous solution.

The alkaline aqueous solution contains water and an alkaline substance. Examples of the alkaline substance include alkali metal hydroxides such as sodium hydroxide (NaOH) and potassium hydroxide (KOH), and organic alkalis such as tetramethylammonium = hydroxide. The pH of the alkaline aqueous solution is preferably 9 or more, more preferably 12 or more, and still more preferably 13 or more from the viewpoint of further promoting the hydrolysis of the glycolic acid polymer. The upper limit value of the pH can be, for example, 14. The pH is a value measured by a pH meter at 20°C. The pH of the alkaline aqueous solution can be adjusted by the amount of the alkaline substance.

The temperature of the polishing liquid W is not particularly limited, and may be 1°C or higher and 60°C or lower.

The polishing liquid W may further contain other components than the ones described above, for example, a hydrolysis accelerator.

### 4. Modified example

In the above-described embodiment, the groove is disposed on the surface of the polishing layer; however, the present invention is not limited thereto, and the groove may not be disposed.

In the above-described embodiment, the polishing pad includes only the polishing layer; however, the present invention is not limited thereto, and another layer may be further included. When the polishing pad further includes a substrate layer, the polishing layer may be uniformly disposed on the substrate layer or may be disposed in a pattern.

In the above-described embodiment, the example in which the glycolic acid polymer is used as the binder resin of the polishing layer has been described; however, the present invention is not limited to this example, and a hydrolyzable resin in which the thickness reduction rate of the composition excluding the abrasive grains satisfies the above-described range can also be used.

### EXAMPLES

Hereinafter, the present disclosure will be described with reference to Examples. The scope of the present disclosure is not to be construed as being limited by Examples.

### 1. Material

### 1-1. Binder resin

· PGA-1 (glycolic acid homopolymer, weight average molecular weight: 298000)
· PGA-2 (glycolic acid homopolymer, weight average molecular weight: 115000)
· PLA (NatureWorks 7000D available from NatureWorks LLC, polylactic acid, weight average molecular weight: 246000)
· PPS (polyphenylene sulfide, weight average molecular weight: 60400)

The weight average molecular weight of each resin was measured by gel permeation chromatography (GPC).

### Weight average molecular weights of PGA and PLA

Device: Shodex-104, available from Showa Denko K.K.
Columns: two HFIP-606M and, as a precolumn, one HFIP-G were connected in series
Column temperature: 40°C
Eluent: HFIP solution in which 5 mM sodium trifluoroacetate is dissolved
Flow rate: 0.6 mL/min
Detector: RI (differential refractive index) detector
Molecular weight calibration: five types of standard polymethylmethacrylates having different molecular weights

### Weight average molecular weight of PPS

Apparatus: High-temperature GPC SSC-7000 available from Senshu Scientific Co., Ltd.
Column temperature: 210°C
Eluent: 1-chloronaphthalene
Flow rate: 0.7 mL/min
Detector: UV detector (360 nm)
Molecular weight calibration: five types of standard polystyrenes having different molecular weights

### 1-2. Abrasive grain

GC fine abrasive of #800 (polishing material of silicon carbide, available from NANIWAABRASIVE MFG. CO., LTD.)

### 1-3. Hydrolysis accelerator

Glycolide: pyromellitic anhydride = 14: 5 (weight ratio)

### 2. Preparation and evaluation of polishing pad

### 2-1. Preparation of polishing pad

### Examples 1 to 3, Comparative Examples 1 and 2

### (1) Kneading step

The binder resin illustrated in Table 1 was weighed so as to be 67 vol% (Examples 1 to 3: 50 mass%, Comparative Example 1: 44 mass%, Comparative Example 2: 46 mass%), and the GC fine abrasive of #800 (available from NANIWA ABRASIVE MFG. CO., LTD.) was weighed so as to be 33 vol% (Examples 1 to 3: 50 mass%, Comparative Example 1: 56 mass%, Comparative Example 2: 54 mass%), and the binder resin and the GC fine abrasive were kneaded using Labo Plastomill (available from Toyo Seiki Seisaku-sho, Ltd.) to obtain a composition. The kneading was performed at a predetermined heater temperature for a preheating time of 1 minute, a kneading time of 5 minutes, and a rotation speed of 50 rpm. The heater temperature was set to 250°C for PGA, 200°C for PLA, and 320°C for PPS, and the kneading was performed.

### (2) Molding step

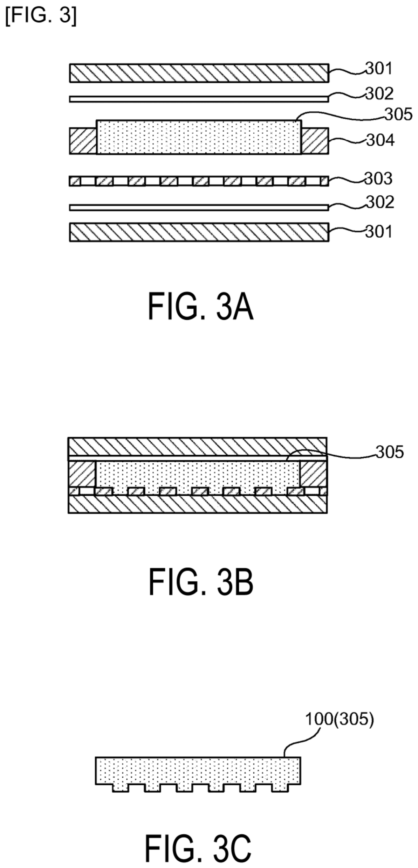

FIGS. 3A to 3C are schematic cross-sectional views illustrating a molding step in Examples. In the drawing, reference numeral 301 denotes a ferro plate, and reference numeral 302 denotes an aluminum foil.

As illustrated in FIG. 3, an aluminum punching sheet 303 having a thickness of 0.3 mm, in which through holes having a diameter of 3 mm were arranged at intervals of 5 mm, was prepared.
An SUS mold 304 having a hole with a diameter of 150 mm and a thickness of 0.5 mm was disposed on the aluminum punching sheet 303 as illustrated in FIG. 3, a composition 305 kneaded as described above was set in the SUS mold 304, and press-molded to obtain the polishing pad 100 including a polishing layer having a thickness of 0.8 mm and a groove disposed on the surface as illustrated in FIGS. 1A and 1B. The temperature of a pressing machine was set to the same temperature as the heater temperature of the Labo Plastomill.

### 2-2. Evaluation

Since the abrasive grains of the polishing pad immediately after molding were buried in the resin, a polishing test was performed after dressing with a grinding wheel of #800.

### Polishing test

As illustrated in FIG. 2, the polishing test was performed by attaching the polishing pad to the polishing apparatus 200. Specifically, the polishing pad was attached to the platen 210 (polishing platen) using a double-sided adhesive film (for example, AS ONE OCA50-A4). A double-sided adhesive sheet was bonded to the polishing pad and the polishing platen using a rubber roller or the like so that air bubbles did not enter during the bonding.

Next, a 15 × 15 mm square Si substrate as the object to be polished 220 was pressed against the rotating polishing pad to perform polishing processing. The polishing conditions were as follows. At this time, loads of the jig (polishing head 230) and the weight 240 are applied to the substrate.

### Polishing test 1

Polishing apparatus: Dialap ML-150P (available from MARUTO INSTRUMENT CO., LTD.)
Rotational speed of polishing platen: 100 rpm
Polishing platen diameter: diameter 150 mm
Forced driving and swinging of object to be polished: none
Surface pressure: 440 gf/cm²
Flow rate of polishing liquid: 100 mL/min.
Polishing liquid: NaOH aqueous solution (20°C) with pH = 9

### Polishing test 2

Polishing apparatus: Dialap ML-150P (available from MARUTO INSTRUMENT CO., LTD.)
Rotational speed of polishing platen: 100 rpm
Polishing platen diameter: diameter 150 mm
Forced driving and swinging of object to be polished: none
Surface pressure: 440 gf/cm²
Flow rate of polishing liquid: 100 mL/min.
Polishing liquid: NaOH aqueous solution (20°C) with pH = 13

The polishing speed at the time of polishing using each polishing liquid was measured by the following method.

### Polishing speed

The object to be polished was attached to a jig with wax and polished. In this attached state, the thickness of the object to be polished was measured by an electric micrometer Millimar1240 (available from Mahr GmbH).

The thickness of the object to be polished was measured at five points, and an average value thereof was taken. The polishing speed was obtained by calculation from the polishing time (min) and a thickness decrease value (removal amount, µm).

The configurations and tensile strengths of the polishing pads of Examples 1 to 3 and Comparative Examples 1 to 2 are presented in Table 1. The tensile strength indicates a tensile strength measured in accordance with ISO527 for the composition in a state in which the abrasive grains are removed. The results of performing a polishing test 1 and a polishing test 2 using the polishing pads obtained in Examples 1 to 3 and Comparative Examples 1 to 2 are presented in Table 2.

**[Table 1]**

| | | Example 1 | Example 2 | Example 3 | Comparative Example 1 | Comparative Example 2 |
|---|---|---|---|---|---|---|
| Configuration | Binder resin | PGA-1 | PGA-2 | PGA-1 | PLA | PPS |
| | Weight average molecular weight Mw | 298000 | 115000 | 298000 | 246000 | 60400 |
| | Content of abrasive grain/wt% (/Vol%) *1 | 50 (33) | 50 (33) | 50 (33) | 56 (33) | 54 (33) |
| | Hydrolysis accelerator | - | - | PGA/degradation accelerator = 81/19 (wt%) | - | - |
| Physical properties | Tensile strength/MPa *2 | 112.8 | 115.1 | 65.1 | 62.7 | 93 |

| | | | | | | |
|---|---|---|---|---|---|---|
| *1: vol.% relative to total volume of polishing layer *2: Tensile strength of composition excluding abrasive grain | | | | | | |

**[Table 2]**

| | Polishing test 1 (pH = 9) | | | | Polishing test 2 (pH = 13) | | | |
|---|---|---|---|---|---|---|---|---|
| | Polishing speed [µm/min] | | | | Polishing speed [µm/min] | | | |
| | 15 min 30 | 30 min. | 45 min | 160 min | 15 min | 30 min | 145 min | min |
| Example 1 | 0.13 | 0.08 | 0.04 | 0.02 | 1.05 | 0.89 | 1.05 | 1.26 |
| Example 2 | 0.16 | 0.06 | 0.04 | 0.03 | 1.45 | 1.13 | 1.63 | 1.22 |
| Example 3 | - | - | - | - | 1.64 | 2.49 | 2.25 | 2.02 |
| Comparative Example 1 | 0.03 | 0.03 | -0.04 | 0.00 | 0.18 | 0.06 | 0.06 | 0.04 |
| Comparative Example 2 | 0.07 | 0.02 | 0.01 | 0.01 | 0.16 | 0.15 | 0.13 | 0.11 |

As presented in Tables 1 and 2, in the polishing pads of Comparative Examples 1 and 2 using PLA or PPS as the binder resin, the polishing speed was low at both pH 9 and pH 13, and the polishing speed gradually decreased from the polishing speed for the first 15 minutes. This indicates that although the abrasive grains exposed on the surface of the polishing pad initially act on polishing, the abrasive grains acting on polishing gradually decrease. That is, it is considered that since the binder resin did not degrade sufficiently, resulting in a lack of the abrasive grain renewal, the polishing speed decreased.

On the other hand, in the polishing pad of Examples 1 to 3 using PGA as the binder resin, the polishing speed was high, and no significant decrease in the polishing speed was not observed from the polishing speed for the first 15 minutes to the polishing speed after 60 minutes at pH 13.

From these, it can be seen that in the polishing pad using PGA as the binder resin, the decrease in polishing speed can be reduced without performing dressing.

It is found that the addition of the hydrolysis inhibitor (GL) to PGA can remarkably increase the polishing speed particularly at pH 13 (comparison between Examples 1 and 3).

### 3. Immersion test

### Preparation for test piece

A composition was prepared in the same manner as in the compositions used for the production of the polishing pads of Examples 1 to 3 and Comparative Examples 1 to 2, except that the abrasive grains were not contained. The resin composition was injection-molded to obtain a square column of 10 mm × 10 mm × 120 mm, and a cubic test piece (molded article) having a side of 10 mm was obtained from the square column.

### Immersion test

The resulting test piece was placed in a 1 L autoclave. Then, the autoclave was filled with water (deionized water) at a temperature of 60°C or 80°C, and the test piece was completely immersed at ambient pressure to perform an immersion test.

The test piece after immersion was taken out at predetermined time intervals to prepare test pieces with different immersion times, and each test piece was cut to expose a cross section. After the test piece was left to stand overnight in a dry room and dried, the thickness of the core part (hard portion) of the test piece was measured. The reduced thickness was measured from the difference between the thickness before immersion (initial thickness, specifically 10 mm) and after immersion. The change of the reduced thickness of the test piece over time was determined based on the measured value of the reduced thickness of the test piece measured for different immersion time periods. Then, the thickness reduction rate (unit: mm/h) of the test piece having a thickness of 10 mm was calculated from the time variation for the thickness reduction of the test piece in a range where the thickness reduction of the test piece had linear variation over time.

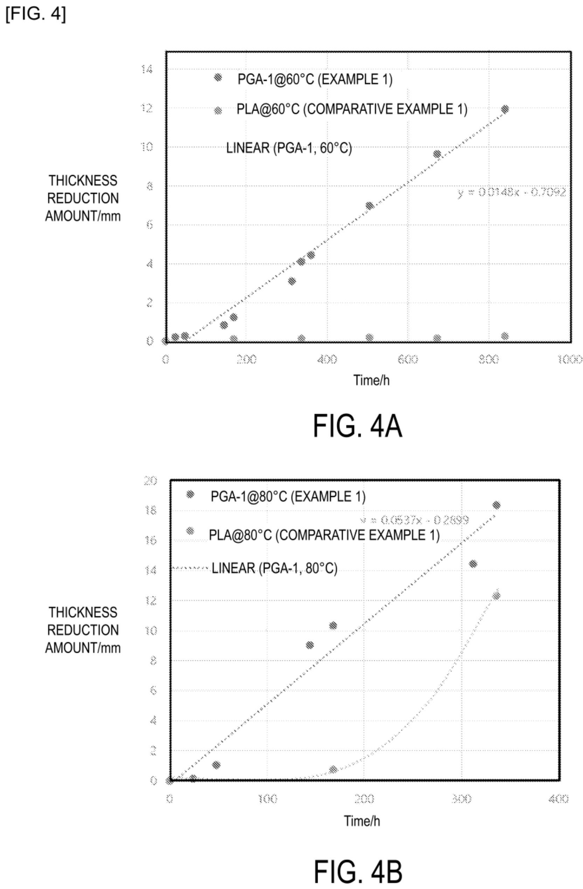

The evaluation results of Examples 1 to 3 and Comparative Examples 1 to 2 at 60°C are presented in Table 3. FIG. 4 is a graph of the evaluation results of Example 1 and Comparative Example 1, in which FIG. 4A illustrates the evaluation results at 60°C, and FIG. 4B illustrates the evaluation results at 80°C.

**[Table 3]**

| | Example 1 | Example 2 | Example 3 | Comparative Example 1 | Comparative Example 2 |
|---|---|---|---|---|---|
| Rate of decrease in thickness (µm/h) | 12.3 | 12.9 | 86 | 0.3 | 0 |

As illustrated in Table 3, it is found that while the thickness reduction rate of the molded articles of Examples 1 to 3 is as large as 12 µm/h or more, the thickness reduction rate of the molded articles of Comparative Examples 1 and 2 is smaller than the value. That is, it is considered that a processing rate is not maintained in the polishing pad of Comparative Examples 1 to 2 as presented in Table 2 because the binder resin did not degrade sufficiently.

As illustrated in FIG. 4, PGA of Example 1 exhibits surface degradability in which the thickness decreases at a constant rate even in water at a temperature of 60°C and 80°C. On the other hand, in PLA of Comparative Example 1, a degradation rate is significantly lower than that in PGA at 60°C. In addition, when the temperature was raised to 80°C to promote hydrolysis, a behavior of bulk degradability was exhibited in which the thickness reduction rate was accelerated with lapsing time. That is, even if the hydrolysis is further promoted when PLA is used as the binder resin, excessive degradation occurs due to bulk degradation, and it is considered that not only the life of the polishing pad is shortened but also a stable dressing effect cannot be obtained. From these, it is found that PGA exhibiting surface degradability is suitable as a polishing pad in the polishing pad that maintains a stable dressing effect and a stable polishing speed.

The present application claims priority to Japanese patent application No. 2023-091781 filed on June 2, 2023. The contents described in the specifications and drawings of the priority application are incorporated by reference in its entirety to the specification of the present application.

### INDUSTRIAL APPLICABILITY

According to the present invention, it is possible to provide a polishing pad in which a decrease in polishing speed is small and a method for polishing an object to be polished using the polishing pad.

### REFERENCE SIGNS LIST

100 Polishing pad
110 Polishing layer
110A Groove
111 Matrix portion
112 Abrasive grain
200 Polishing apparatus
210 Platen
220 Object to be polished
230 Polishing head
230A: Rotation shaft
240 Weight
250 Supply nozzle
301 Ferro plate
302 Aluminum foil
303 Aluminum punching sheet
304 SUS mold
305 Composition

## Claims

1. A polishing pad, comprising a polishing layer comprising a composition containing a glycolic acid polymer and an abrasive grain.

2. The polishing pad according to claim 1, wherein a median diameter of the abrasive grain is 2 µm or more and 50 µm or less.

3. The polishing pad according to claim 1 or 2, wherein a weight average molecular weight of the glycolic acid polymer is 70000 or more.

4. The polishing pad according to any one of claims 1 to 3, wherein the polishing layer further contains a hydrolysis accelerator that promotes hydrolysis of the glycolic acid polymer.

5. The polishing pad according to any one of claims 1 to 4, wherein the hydrolysis accelerator includes a cyclic ester.

6. The polishing pad according to any one of claims 1 to 5, wherein a thickness reduction rate when a molded article of the composition excluding the abrasive grains is immersed in 60°C water is 12 µm/h or more.

7. The polishing pad according to any one of claims 1 to 6, wherein a tensile strength of the molded article including the composition excluding the abrasive grains is 55 MPa or more.

8. A method for polishing an object to be polished, the method comprising polishing the object to be polished by sliding the polishing pad and the object to be polished relative to each other while supplying, to a surface of the polishing layer of the polishing pad described in any one of claims 1 to 7, a polishing liquid containing water.

9. The method for polishing an object to be polished according to claim 8, wherein the polishing liquid is an alkaline aqueous solution.
